Europäisches Patentamt

European Patent Office

Office européen des brevets

(11) Veröffentlichungsnummer: **0 403 005**
**A2**

## (12) EUROPÄISCHE PATENTANMELDUNG

(21) Anmeldenummer: **90201489.3**

(22) Anmeldetag: **11.06.90**

(51) Int. Cl.$^5$: **C23C 16/50**

(30) Priorität: **16.06.89 DE 3919724**

(43) Veröffentlichungstag der Anmeldung:
**19.12.90 Patentblatt 90/51**

(84) Benannte Vertragsstaaten:
**DE FR GB**

(71) Anmelder: **Philips Patentverwaltung GmbH**
**Wendenstrasse 35 Postfach 10 51 49**
**D-2000 Hamburg 1(DE)**
(84) **DE**

Anmelder: **N.V. Philips' Gloeilampenfabrieken**
**Groenewoudseweg 1**
**NL-5621 BA Eindhoven(NL)**
(84) **FR GB**

(72) Erfinder: **Gärtner, Georg, Dr.**
**Reinhardstrasse 66A**
**D-5100 Aachen(DE)**
Erfinder: **Van Hal, Henricus Albertus Maria**
**Mr. de la Courtstraat 8**
**NL-5512 AS Vessem(NL)**

(74) Vertreter: **Piegler, Harald, Dipl.-Chem. et al**
**Philips Patentverwaltung GmbH**
**Wendenstrasse 35 Postfach 10 51 49**
**D-2000 Hamburg 1(DE)**

(54) **Verfahren zur Herstellung von erdalkalimetallhaltigen und/oder erdalkalimetalloxidhaltigen Materialien.**

(57) Bei der Herstellung von erdalkalimetallhaltigen und/oder erdalkalimetalloxidhaltigen Materialien, insbesondere von Hochtemperatursupraleitern (HT$_c$SL), aber auch von Erdalkali-Nachlieferungskathoden, durch plasmaaktivierte reaktive Abscheidung aus der Gasphase (PCVD), wobei mindestens eine metallorganische (MO) Verbindung der Erdalkalimetalle in die Gasphase überführt wird, werden die MO-Verbindungen der Erdalkalimetalle aus jeweils einem Niederdruck-Feststoffverdampfer mittels eines ein Inertgas und/oder ein oxidierendes Gas enthaltenden Trägergases in ein Entladungsgefäß überführt. In dem Entladungsgefäß wird ein Gesamtdruck im Bereich von 0,1 bis 50 hPa eingestellt und es wird ein Plasma (5) erzeugt, wobei wiederholt-intermittierend zur plasmaaktivierten Abscheidung aus einer die MO-Verbindungen und das oxidierende Gas als reaktive Gase und das Inertgas enthaltenden Phase eine Argon/Sauerstoff-Zwischenbehandlung durchgeführt wird.

Fig.1

## Verfahren zur Herstellung von erdalkalimetallhaltigen und/oder erdalkalimetalloxidhaltigen Materialien

Die Erfindung betrifft ein Verfahren zur Herstellung von erdalkalimetallhaltigen und/oder erdalkalimetalloxidhaltigen Materialien durch plasmaaktivierte reaktive Abscheidung aus der Gasphase, wobei mindestens eine metallorganische Verbindung der Erdalkalimetalle in die Gasphase überführt wird.

Ein derartiges Verfahren ist aus EP-A-0 194 748 bekannt, wobei dünne magnetische Schichten von $BaFe_{12}O_{19}$ hergestellt werden. Dabei wird Barium in Form von Diethoxy-Barium = $Ba(OC_2H_5)_2$ aus einer flüssigen Lösung in Ethanol durch Hindurchleiten eines Trägergases in Tröpfchenform (in Ethanol) in einen Reaktionsraum überführt und mit Sauerstoff als Reaktionsgas in einem Hochfrequenzplasma, einem Magnetronentladungsplasma oder einem Elektron-Cyclotron-Plasma unter einem niedrigen Druck von $1,33.10^{-4}$ bis 13,3 hPa zur Reaktion gebracht. Es handelt sich also um eine Sprüh-Plasmolyse oder PCSD (plasma-chemical spray deposition, vergl. Yee in Int. Met. Rev. 23 (1) (1978) 19-42, insbes. S. 23, rechte Spalte). Nachteile dieses Verfahrens sind eine niedrige Barium-Überführungsrate (Barium-Abscheidungsratenanteil nur einige $10^{-3}$ $\mu m/min$) und eine nicht zu vermeidende Mitabscheidung von Kohlenstoff.

Beispiele für erdalkalimetalloxidhaltige Materialien sind die aus EP-A-0 275 343, EP-A-0 282 199 und WO-A-88/05029 bekannten Hochtemperatursupraleiter (HT$_c$SL). Es handelt sich dabei um keramisches Material, u.a. mit der Zusammensetzung $YBa_2Cu_3O_{7-\delta}$. Die übliche Herstellung dieses Materials erfolgt entweder durch Mischen der Oxidpulver, Erwärmung, Pressen und Sintern oder durch naßchemische Herstellung mit anschließender Wärmebehandlung, Pressen und Sintern.

$YBa_2Cu_3O_{7-\delta}$ ist vom Perowskit-Typ und sollte eigentlich kubisch sein mit den Hauptachsen a = b = c. Supraleitend sind jedoch nur die tetragonale Phase (a = b ≠ c) bis 30 K und die orthorhombische Phase (a ≠ b ≠ c) bis etwa 90 K. Letztere wird bei anschließendem langsamem Abkühlen in genügend sauerstoffhaltiger Atmosphäre erhalten. Die tetragonale Phase erhält man bei schnellem Abschrecken oder bei der Abkühlung in inerter Argon-Atmosphäre, in Stickstoff oder unter Vakuum. Bislang noch ungelöste Probleme bei den Hochtemperatursupraleitern gibt es u.a. im Hinblick auf technische Anwendungen wie z.B. supraleitende Magnete. Dafür sind diese Materialien z.B. in Draht- oder Spulenform erforderlich. Außerdem müssen die Materialien auch bei hohen Stromdichten und starken Magnetfeldern supraleitend bleiben.

Dünne YBa-Cuprat-Schichten, die zur Herstellung von monolithischen Schaltkreisen verwendbar sein könnten, wurden zwar von Behrman et al. (Adv. Ceram. Mat. 2, No. 3B, (1987) 539-555) bereits auch durch plasmaaktivierte reaktive Abscheidung aus der Gasphase (PCVD) hergestellt, jedoch geben Behrman et al. hierzu weder Ausgangsverbindungen noch Verfahrensbedingungen an und es fehlt ein Nachweis der HT$_c$SL-Eigenschaften.

Die Herstellung von HT$_c$SL durch reaktive Abscheidung aus einer metallorganische (MO) Verbindungen enthaltenden Gasphase (MOCVD) ist durch Berry et al. aus Appl.Phys.Lett. 52 (20) vom 16.05.1988 bekannt. Als Ausgangsverbindungen für "YBaCuO" (kurz für YBa-Cuprat) wurden Metall-Alkoxide und Metall-$\beta$-diketonate verwendet, wobei speziell $Cu(acac)_2$, $Y(thd)_3$ und $Ba(thd)_2$ genannt werden. Stickstoff wurde als Trägergas über die erhitzten Ausgangsmaterialien geleitet und später (nach Durchgang durch einen $H_2O$-Bubbler) mit Sauerstoff gemischt. Die Abscheidung erfolgte bei $400^\circ C$ auf einem MgO-Substrat. Die abgeschiedenen amorphen Filme wurden anschließend bei 890 bis $920^\circ C$ unter Sauerstoff getempert. Das bekannte Verfahren hat jedoch mehrere wesentliche Nachteile: Die Übergangstemperatur zum Widerstand 0 liegt nur bei 20 K und die orthorhombische HT$_c$SL-Phase ist höchstens als Beimischung enthalten. Die gewünschte orthorhombische HT$_c$SL-Phase konnte also mit diesem Verfahren nicht isoliert hergestellt werden. Außerdem sind die Wachstumsraten mit 0,008 $\mu m/min$ sehr niedrig. Dies beruht vermutlich darauf, daß die Versuche bei Atmosphärendruck durchgeführt wurden und damit auch keine wirkungsvollen Niederdruckverdampfer verwendbar waren.

Eine japanische Gruppe hat ebenfalls MOCVD-Verfahren zur Herstellung von HT$_c$SL verwendet (Superconductor Week, 11.07.1988, S. 6). Hier wurden als Ausgangsverbindungen $Y(C_{11}H_{19}O_2)_3$ = $Y(thd)_3$, $Ba(C_{11}H_{13}O_2)_2$ (möglicherweise $Ba(thd)_2$) und $Cu(thd)_2$ verwendet. Abgeschieden wurde YBaCuO bei 800 bis $900^\circ C$ und Drucken im Reaktor von 6,67 bis 13,3 hPa. Die höchste damit erreichte Sprungtemperatur $T_c$ war 84 K auf MgO- oder $SrTiO_3$-Substrat. Hier ist die erzielte Wachstumsrate ebenfalls nur sehr niedrig, nämlich 0,017 $\mu m/min$. Offensichtlich konnte kein wirkungsvoller Verdampfer für die metallorganischen Ausgangsverbindungen angewendet werden und außerdem handelt es sich um eine rein thermische Abscheidung bei relativ hohen Temperaturen, was eine großflächige Abscheidung dieses Mehrkomponentenmaterials praktisch unmöglich macht. Schließlich sind mit beiden Verfahren keine verwendbaren HT$_c$SL-Spulenanordnungen herstellbar.

Ähnliches gilt für das aus DE-A-37 34 069 bekannte Verfahren zur Abscheidung von Schichten aus einem oxidkeramischen Supraleitermaterial auf einem Substrat.

Neben diesen CVD-Verfahren zur Herstellung von $HT_cSL$ sind auch schon CVD-Verfahren zur Herstellung von oxiddotierten metallischen Schichten bekannt, wobei dort jedoch vor allem Kathodenmaterialien das Herstellungsziel sind.

So wird in EP-B-0 081 270 neben CVD auch PCVD zur Herstellung der oxiddotierten, metallisch leitenden Schichten genannt, die dann in EP-A-0 204 356 z.B. als glimmentladungsaktivierte CVD in einem rohrförmigen Reaktor realisiert wird. Weiterhin werden in EP-A-0 081 270 Metall-$\beta$-diketonate, aber auch Metallocene, Metallalkoholate und andere MO-Verbindungen als Ausgangsverbindungen für die Metall-Metalloxid-Abscheidung genannt. Speziell zur Herstellung von $Y/Y_2O_3$ werden Y-(acac)$_3$, Y(tfa)$_3$ und Y(hfa)$_3$ genannt, wobei Y-Oxid auch eine Komponente der YBaCuO-$HT_cSL$ darstellt.

Schließlich ist aus EP-A-0 277 680 ein Niederdruckfeststoffverdampfer z.B. für Metall-$\beta$-diketonate bekannt, der geeignet ist, hohe konstante Massenflüsse der MO-Verbindungen zu realisieren.

Der Erfindung liegt die Aufgabe zugrunde, die Herstellung von erdalkalimetallhaltigen und/oder erdalkalimetalloxidhaltigen Materialien, insbesondere von $HT_cSL$-Materialien, zu vereinfachen und gleichzeitig schon bei niedriger Herstellungstemperatur die $HT_cSL$-Phase, bei YBa-Cuprat also die orthorhombische Phase, zu erhalten, und weiterhin auch von den bisherigen geometrischen Beschränkungen frei zu werden.

Diese Aufgabe wird erfindungsgemäß dadurch gelöst, daß bei einem Verfahren der eingangs genannten Art die metallorganischen Verbindungen der Erdalkalimetalle aus jeweils einem Niederdruck-Feststoffverdampfer mittels eines ein Inertgas und/oder ein oxidierendes Gas enthaltenden Trägergases in ein Entladungsgefäß überführt werden, in dem Entladungsgefäß ein Gesamtdruck im Bereich von 0,1 bis 50 hPa eingestellt wird und ein Plasma erzeugt wird, und wiederholt-intermittierend zur plasmaaktivierten Abscheidung aus einer die metallorganischen Verbindungen und das oxidierende Gas als reaktive Gase und das Inertgas enthaltenden Phase eine Argon/Sauerstoff-Zwischenbehandlung durchgeführt wird.

Hinsichtlich der verwendbaren MO-Verbindungen der Erdalkalimetalle sei bemerkt, daß bei Barium bisher ausreichend flüchtige Ausgangsverbindungen, d.h. Verbindungen mit einem Dampfdruck von etwa 0,1 bis 1 hPa bei etwa 150 °C, nicht bekannt waren und/oder bezüglich ihrer Flüchtigkeit noch nicht untersucht worden sind, d.h. es gibt keine Dampfdruckdaten. Wegen ihrer stark ionischen Bindungen gilt das übrigens für die Verbindungen aller Erdalkalimetalle, für die daher bisher ein CVD-Einsatz nicht möglich war. Nun gibt es jedoch verschiedene Möglichkeiten, stabilere und flüchtigere metallorganische Ausgangsverbindungen zu erhalten. So nimmt die Stabilität und die Flüchtigkeit bei den $\beta$-Diketonaten in der Reihenfolge Acetylacetonat < Propionylacetonat sowie mit zunehmendem Grad der Fluorierung zu. Insbesondere gilt für die Flüchtigkeit der jeweiligen Metall-$\beta$-diketonate: Acetylacetonat = (acac) < Heptafluordimethyloctandionat = (fod) < (tfa) < (hfa).

Daher sind von den verwendbaren $\beta$-Diketonaten Ba(acac)$_2$, Ba(tfa)$_2$, Ba(hfa)$_2$ und Ba(thd)$_2$ vor allem Ba(hfa)$_2$ und Ba(tfa)$_2$ vorzuziehen. Dabei ist zu berücksichtigen, daß es beim Verdampfen eine starke Tendenz zur Polymerisation z.B. zu Ba$_2$-(thd)$_4$ gibt. Letztere Verbindung zeigt bei etwa 320 °C geringe Flüchtigkeit und ist daher für PCVD-Anwendungen oberhalb 320 °C Substrattemperatur verwendbar. Ba-bistropolonat = BaT$_2$ . 2 H$_2$O = Ba(C$_7$H$_5$O$_2$)$_2$ . 2 H$_2$O muß sogar bis 400 °C erhitzt werden, um eine nachweisbare Flüchtigkeit zu erzielen. Weitere geeignete Ausgangsverbindungen sind:

Ba(trifluoroacetylpivaloylmethanat)$_2$
Ba(pentafluoropropanoylpivaloylmethanat)$_2$
Ba(heptafluorobutanoylpivaloylmethanat)$_2$.

Insbesondere ist wegen seiner relativ hohen Flüchtigkeit Ba-Hexafluorpropionylacetonat = Ba-(hfp)$_2$ geeignet. Weitere Möglichkeiten sind:
Ba-p-fluoro-p-methylbenzoylacetonat
Ba-1-(4-fluorophenyl)-1,3-pentandionat
und Ba-n-fluoro-$\beta$-dicarbonyl-Verbindungen.

Eine Dampfdruckerhöhung wird auch bei der Ersetzung in der Richtung Ba→Ca→Sr→Mg erreicht. So ist für einige Anwendungen die bei Polymerisation beim Verdampfen entstehende Verbindung CaBa(thd)$_4$ interessant.

Eine zusätzliche erfindungsgemäße Möglichkeit ist die Stabilisierung und Dampfdruckerhöhung durch Herstellung von Mehrmetall-$\beta$-diketonaten, die z.B. Barium und Yttrium enthalten, etwa als BaY(thd)$_5$.

Als richtungsweisende Tendenz ist jedenfalls deutlich gemacht, daß die starke ionische Ba-Bindung durch Umhüllung des Ba mit Chelat-Komplexen dann doch zu transportierbaren Ba-Verbindungen führt.

Ebenfalls ein Beispiel für diesen im Trend liegenden Verbindungstyp für ein anderes Element, hier Gallium, ist das kürzlich hergestellte Tris-aren-Ga(I), wobei das Ga-Ion von [2,2,2] Paracyclophan komplett umschlossen ist.

Für Mehrmetall-MO-Verbindungen ist z.B. [2-CH$_3$)$_2$NCH$_2$C$_6$H$_4$] $_2$.CuBa ein interessanter Kandidat, der schon für Au statt Ba hergestellt wurde. Eine zusätzliche Fluorierung ist vorzusehen.

Der Vollständigkeit halber seien noch genannt, wobei eventuell strukturelle Ersetzungen und/oder Erweiterungen durchzuführen sind:
Ba-Tris(oxalato(2-)$O^1,O^2$) Yttrium(III) (hexahydrat),
Ba-Diacetyldioxim
und schließlich
Ba-4',4'-diamino 3,3'-(4'',4''' biphenylenebisazo)-1, $1^L$bis-naphthalensulfonat) = $C_{32}H_{22}N_5BaO_6S_2$; S-Rückstände müssen hierbei bei einer Plasma-Nachbehandlung entfernt werden.

Als weitere Möglichkeit zum Gasphasentransport von Ba gibt es schließlich noch die sogenannten ligand-stabilisierten Metallcluster, z.B. ($Ba_{13}$ + Liganden) für die erste abgeschlossene Schale mit der magischen Zahl 13.

Die insbesondere für die Herstellung von $HT_cSL$ benötigten weiteren metallorganischen Ausgangsverbindungen sind für Kupfer und Yttrium $\beta$-Diketonate, insbesondere Cu-hexafluoracetylacetonat = Bis(1,1,1,5,5,5-hexafluoropentandionato)Cu-(II) = $Cu(hfa)_2$ = $Cu(C_5HF_6O_2)_2$ oder Cu-trifluoracetylacetonat = $Cu(tfa)_2$ sowie $Y(tfa)_3$ oder $Y(thd)_3$ = Yttrium-tetramethylheptandionat.

Wesentlich für die Erfindung ist es, daß für die flüchtigen Barium-, Strontium- oder Calcium-MO eine Niederdruck-PCVD mit einem Niederdruck-Feststoff-Verdampfer eingesetzt wird, der hohe konstante Überführungsraten bei stabil bleibender Ausgangsverbindung erlaubt, da er unter dem Schmelzpunkt der jeweiligen Substanz betrieben wird. Derartige Niederdruck-Feststoff-Verdampfer sind aus EP-A-0 277 680 bekannt und in EP-A-0 325 319 vorgeschlagen worden, deren Anmeldungsunterlagen als Bestandteil der vorliegenden Beschreibung anzusehen sind.

Dieser Verfahrensschritt hat den Vorteil, daß die Erdalkalimetall-Verbindungen kurz unterhalb ihres jeweiligen Schmelzpunktes noch genügend stabil sind und wegen des niedrigen Drucks in der Verdampferkammer mit einem bis zu zwanzigfach höheren Fluß überführt werden können (im Vergleich zu Verdampfern bei Atmosphärendruck). Damit sind also konstant hohe Überführungsraten erzielbar.

Zusätzlich wird als Hauptbestandteil der in das Entladungsgefäß einströmenden Gase eine $Ar/O_2$-Mischung verwendet, die auch als Trägergas für die obengenannten metallorganischen Ausgangsverbindungen dient, welche sich in vorgeheizten, thermostatisierten Verdampfern befinden. Als Trägergase und Hauptkomponenten im Plasma können statt Argon auch andere Edelgase und statt Sauerstoff als oxidierendes Gas auch $N_2O$ oder ein $O_2/H_2O$-Gemisch verwendet werden. Ungünstig ist hingegen nur $Ar/H_2O$ oder ein $H_2/H_2O$-Gemisch.

Außerdem ist es bei dem erfindungsgemäßen MO-(LP)-PCVD-Verfahren unbedingt erforderlich, zur Abscheidung der oxidischen Phasen und zur Verhinderung von Kohlenstoff-Einbau eine kurz intermittierende $Ar/O_2$-Plasma-Zwischenbehandlung durchzuführen, wie sie in EP-A-0 324 523 beschrieben ist, deren Anmeldungsunterlagen als Bestandteil der vorliegenden Beschreibung anzusehen sind.

Dadurch wird eine Verhinderung bzw. mehr als zwanzigfache Verringerung des ansonsten bei MOCVD unvermeidlichen Kohlenstoffeinbaus erzielt. Bei periodisch hin- und herbewegtem Plasma (siehe weiter unten) ist dieses $Ar/O_2$-Plasmazwischenbehandlungsintervall typisch eine halbe oder ganze Zykluszeit.

Um Ausbeuteverluste zu vermeiden, können bei der intermittierenden Zwischenbehandlung entweder die Verdampfer geschlossen werden, oder es wird bei einer Umweglösung mit zwei Zwillingsapparaturen gefahren, in denen immer abwechselnd PCVD-beschichtet und zwischenbehandelt wird. Die $Ar/O_2$-Plasmazwischenbehandlung hat auch den Vorteil, daß eine sonst mehrere Stunden dauernde Temperaturnachbehandlung unter Sauerstoff-Atmosphäre bei 650° bis 850°C sehr verkürzt wird oder überflüssig wird, was die schädliche Interdiffusion zwischen Substratmaterial und $HT_cSL$-Schicht stark verringert. Durch Einstellung der Plasma-Leistungsdichte, der Sauerstoffkonzentration und der Substrattemperatur wird direkt die orthorhombische $YBa_2Cu_3O_{7-\delta}$-Phase abgeschieden bzw. bei der $(Ar)/O_2$-Plasma-Zwischenbehandlung bevorzugt erzielt.

Zur Plasma-Aktivierung der reaktiven Gase wird vorzugsweise ein Mikrowellenplasma, ein Hochfrequenz-Plasma und/oder eine Gleichstrom-Glimmentladung angewendet. Die typischen Substrat-Wandtemperaturen liegen dabei zwischen 200 und 400°C, und der Druck im Entladungsgefäß liegt vorzugsweise zwischen 2 und 20 hPa (LPCVD, wobei LP = low pressure = Niederdruck).

Durch periodisches Hin- und Herbewegen des Plasmas werden die $YBa_2Cu_3O_{7-\delta}$-Schichten auf der Innenseite oder der Außenseite eines Rohres abgeschieden.

Vorzugsweise wird die $HT_cSL$-Abscheidung auf der Außenseite eines koaxialen Innenrohres als Substrat durchgeführt, wobei das Substratmaterial so gewählt wird, daß seine Gitterabstände annähernd mit denen von z.B. $YBa_2Cu_3O_7$ in der orthorhombischen Phase übereinstimmen.

Dies bewirkt ein annähernd epitaktisches Aufwachsen und fördert die Ausbildung der $HT_cSL$-Phase, die übrigens bei Temperaturen oberhalb des Übergangs in den supraleitenden Zustand metallisch leitend ist. Verwendet wird zur PCVD ein Hochfrequenz- oder Mikrowellenplasma, das durch ein weiteres dielektrisches Außenrohr in den Reaktionsraum zwischen Substratrohr und diesem Außenrohr eingekoppelt wird. Durch Wahl des Außenrohrmaterials derart, daß die Gitterabstände möglichst wenig mit der orthorhombischen YBaCu$_3$O$_{7-\delta}$-Phase übereinstimmen oder es sich z.B. um amorphe oder glasartige Materialien handelt, wird die Ausbildung einer elektrisch leitenden Schicht auf der Rohrinnenseite vermieden, die anderenfalls die Einkopplung verhindern würde. Als Außenrohrmaterial wird z.B. SiO$_2$-Glas gewählt, als Innenrohr ein SrTiO$_3$-Rohr auf einem geheizten Innenrohr aus Metall (zur Mikrowellenreflexion). Durch eine geeignete, eventuell Facettenzusammensetzung, von SrTiO$_3$-Einkristallflächen der (100)-Orientierung auf der Außenseite des Innenrohres als Substratoberfläche wird ein HT$_c$SL-Wachstum mit der a-Achse senkrecht zur Oberfläche und damit mit der anisotropie-bevorzugten c-Achse in der Fläche erreicht. c-Achse und Stromrichtung sollen wegen der Anisotropie bevorzugt zueinander parallel eingestellt werden, was noch einen weiteren Behandlungsschritt, der weiter unten beschrieben wird, erfordert.

Bei zu niedriger, nicht ausreichender Flüchtigkeit der Ba-Verbindungen werden diese zusätzlich in Feinstpulverform überführt und aus dem Verdampfer mit ausgeblasen. Die Pulver-Kornzerlegung erfolgt dann im Plasma mit anschließender Abscheidung der entsprechenden Oxide.

Die gewünschte Festkörperzusammensetzung wird durch Einstellung der Massenflüsse der drei metallorganischen Komponenten erreicht. Diese wiederum werden über die Verdampfertemperatur der drei MO-Verdampfer und eine vorgeschaltete Massenflußsteuerung für die einzelnen Ar-oder Ar/O$_2$-Trägergasflüsse eingestellt. Typische Werte für die Massenflüsse der MO-Einzelkomponenten sind dann:

Y-$\beta$-diketonat, insbes. Y(thd)$_3$ oder Y(tfa)$_3$ : 1 sccm
Cu-$\beta$-diketonat, insbes. Cu(hfa)$_3$ : 3 sccm
Ba-MO-Verbindung, insbes. Ba(hfp)$_2$ : 2 sccm.

Bei MO-Verbindungen mit mehr als einer der drei Komponenten Ba, Y, Cu wird das in einer solchen Verbindung vorgegebene Verhältnis, formal z.B. Ba$_{2n}$Y$_m$Cu$_p$ (+ Rest), bei einem Massenfluß von 90/n sccm (n > m,p vorgegeben) kompensiert mit zusätzlich (1-m/n) sccm Y-$\beta$-diketonat und (3-p/n) sccm Cu-$\beta$-diketonat.

Einige Ausführungsbeispiele der Erfindung sind in einer Zeichnung dargestellt und werden im folgenden näher beschrieben. In der Zeichnung zeigen

Fig. 1 eine Vorrichtung zur Beschichtung der Außenseite eines Rohres in schematischer perspektivischer Darstellung,

Fig. 2 und 3 Spiralbahnen einer supraleitenden Spule,

Fig. 4 eine Abwandlung der Vorrichtung nach Fig. 1 zur Herstellung von Spiralbahnen gemäß Fig. 2 und 3 und

Fig. 5 eine Vorrichtung zur Herstellung von Kathoden, z.B. für Elektronenstrahlröhren, in schematischer perspektivischer Darstellung.

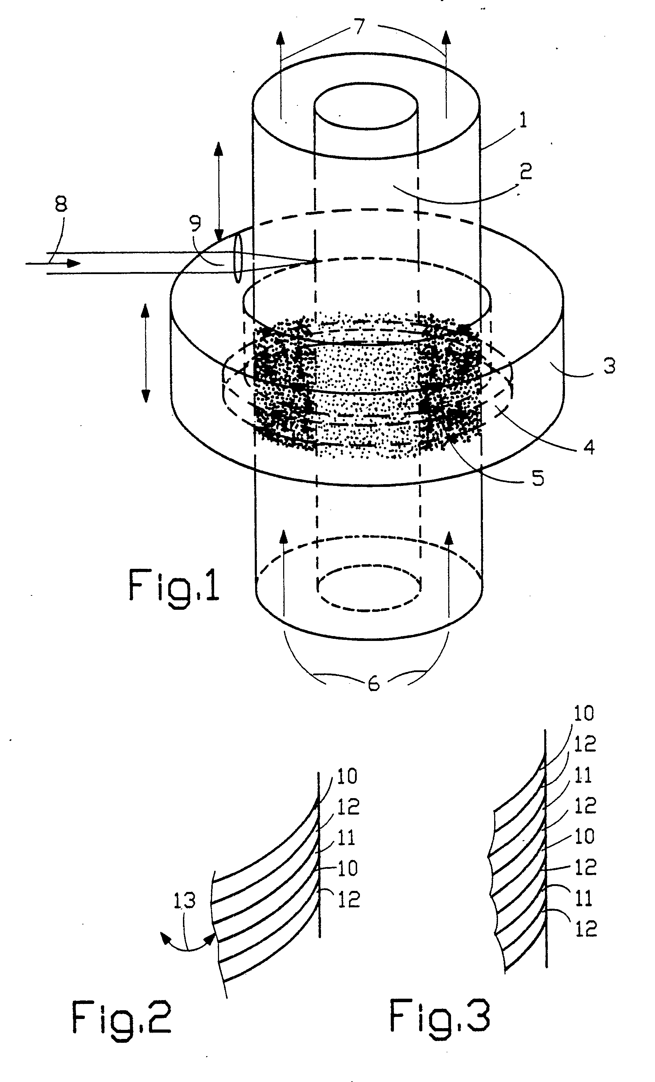

Gemäß Fig. 1 ist in einem Außenrohr 1, bestehend aus SiO$_2$ oder einem anderen für einen IR-Laser strahldurchlässigen Material - für einen CO$_2$-Laser z.B. ZnSe oder mit mindestens einem Fensterbereich aus ZnSe versehen - ein Substratrohr 2, bestehend aus einer SrTiO$_3$- oder MgO-Oberfläche auf metallischem Rohrträger, oder aus oberflächlich im Plasma oxidiertem Cu oder einem sonstigen oberflächlich aufgebrachten Substratmaterial auf einem metallischen Trägerrohr, koaxial derart angeordnet, daß zwischen 1 und 2 die reaktive Gasphase (Ar/O$_2$ + MO-Verbindung) bei 6 einströmt und bei 7 die gasförmigen Reaktionsendprodukte zur Gasentsorgung hin abgesaugt werden. Über dem mikrowellendurchlässigen Außenrohr 1 sitzt ein einseitig über einen Rundum-Koppelschlitz 4 offener Mikrowellenresonator 3, der längs des Außenrohres - z.B. periodisch - verschiebbar ist. Innerhalb des Substratrohres 2 befindet sich eine hier nicht dargestellte Temperaturstabilisierung mit einer Zusatzheizung und/oder -kühlung. Die Mikrowellenzuführung zum offenen Resonator 3, aus dem durch 4 und 1 die Mikrowellen in die reaktive Gaszone austreten und dort ein Plasma 5 ausbilden, ist ebenfalls nicht dargestellt.

Bei der in Fig. 1 dargestellten Ausführungsform können simultan im Prozeß nach Abscheidung jeder Lage durch einen von außen eingestrahlten, durch eine Linse 9 fokussierten Laserstrahl 8 spiralförmige gewendelte Unterbrechungen in die Schicht geschnitten werden. Anschließend wird im Innenbereich mit einer isolierenden Schicht weiterbeschichtet (schmaleres Profil), darauf wird wieder eine supraleitende Schicht abgeschieden usw., bis schließlich so eine supraleitende Spule hergestellt ist.

Eine Variante dieses erfindungsgemäßen Verfahrens besteht darin, durch Änderung der Sauerstoff-Konzentration im Plasma eine nichtleitende Phase abwechselnd auf die supraleitende zu setzen und die Leitertrennung durch Laserstrahlphasenumwandlung zu erzielen. Als Innensubstratrohr 2 wird z.B. ein Rohr mit einer Oberfläche von SrTiO$_3$ oder ein oberflächlich im Plasma oxidiertes Cu-Rohr verwendet. Das Außenrohr ist mikrowellendurchlässig und besteht z.B. aus SiO$_2$ und/oder ZnSe. Über dem Außenrohr 1 sitzt ein koaxialer, nach innen mit einem Kreisschlitz 4 versehener Resonator 3, der (periodisch) linear längs der Achse gesteuert hin- und herbewegt werden kann. Ein Laserstrahl 8 geeigneter Wellenlänge wird durch das Außenrohr auf die Innenrohrsubstratoberfläche fokussiert und bei Betrieb relativ dazu bewegt, so daß eine Spiralwendelspur erzeugt wird. Das kann z.B. durch eine Strahltranslation und eine überlagerte Innenrohrrotation erreicht werden.

Dazu wird an einer der beiden Anschlußstellen der Spiralwendel, z.B. auf der Gaseintrittsseite, polykristallines $YBa_2CuO_{7-\delta}$-Material mit der orthorhombischen c-Achse in der zukünftigen Stromrichtung in direktem Kontakt mit dem polykristallinen PCVD-$HT_cSL$-Material in einem kleinen Bereich vorzugsweise schon vor der PCVD angebracht. Anschließend wird mit einem auf die Spiralbreite gebündelten Laserstrahl ausgehend von dieser Ansatzstelle eine Wärmebehandlung der schon abgeschiedenen dünnen $HT_cSL$-Schicht durchgeführt, wobei die mit ihrer c-Achse in Spiralrichtung orientierten Kristallite von der Ansatzstelle aus bevorzugt wachsen und damit die gewünschte Orientierung erzielt wird. Diese Behandlung wird bei jeder neu abgeschiedenen Spirallage durchgeführt, bis so eine in Spiralrichtung bevorzugt supraleitende Spule hergestellt ist.

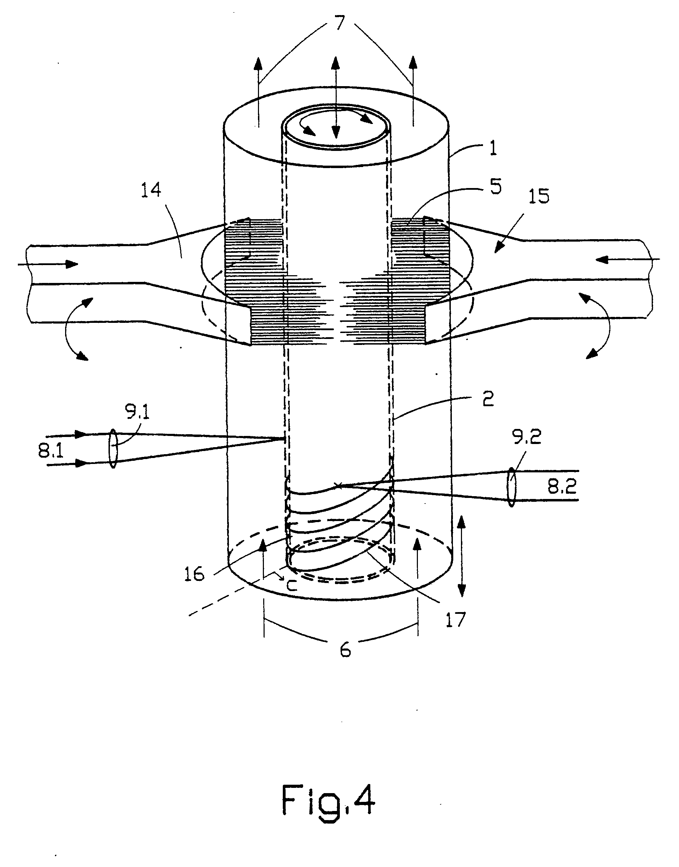

Eine zweite Möglichkeit des orientierten Aufwachsens besteht erfindungsgemäß darin, daß wiederum z.B. auf einem $SrTiO_3$-Substratrohr 2 der obigen Textur wie in Fig. 4 von einer Einkristallit-Ansatzstelle 16 mit orthorhombischer c-Achse (Pfeil c) (allgemein: mit Richtung der bevorzugten Supraleitung im anisotropen Fall) in Spiralsteigungsrichtung 17 tangential zur Oberfläche LI-MOCVD mit den schon erwähnten Ausgangsverbindungen, insbesondere Ba-, Y-und Cu-$\beta$-diketonaten, durchgeführt wird, wobei der (NdYAG-)Laserstrahl 8.2 gebündelt über eine Linse 9.2 in etwa tangential zur Substratrohroberfläche 2 und senkrecht auf die Wachstumsfläche eingestrahlt wird.

Synchron mit der Wachstumsgeschwindigkeit der aufwachsenden $HT_cSL$-Schicht wird dabei das Substratrohr in Richtung der Spiraltangentiale weggedreht, d.h. kontinuierlich axial verschoben und gedreht. Zu einer Entfernung von Kohlenstoff-Resten ist auch hier eine intermittierende $Ar/O_2$-Plasmazwischenbehandlung vorgesehen, oder es wird zusätzlich zum LICVD-Laserstrahl ein schwaches Plasma gezündet.

Weiterhin sind zum Einstellen der gewünschten Textur in der designierten Stromrichtung folgende Verfahrensschritte einzeln oder in Kombination anwendbar:

1) Ausüben von Druck- oder Zugspannungen in fester Korrelation zur designierten Stromrichtung in Verbindung mit einer gleichzeitigen oder nachfolgenden Wärmebehandlung, z.B. lokal per Laser.

2) Wahl geeigneter z.B. fluorierter MO-Verbindungen als reaktive Verbindungen zusammen mit Sauerstoff oder anderen elektronegativen Gasen als Dotierung wie z.B. Chlor, die die CVD-Schichttextur ändern.

3) Elektronenbeschuß oder Ionenbombardement der aufwachsenden $HT_cSL$-Materialoberflächen, wobei z.B. Ionen mit etwa 200 eV mittlerer Energie ein lokales Schmelzen und Umarrangement bewirken.

Weitere Bedingungen bei der Herstellung supraleitender Spulen aus $HT_cSL$-Material sind: Isolierung zwischen den stromführenden Spiralbahnen und Kontakt der einzelnen $HT_cSL$-Bahn mit normalleitendem metallischem Material, um Quenchströme bei plötzlichem Temperaturanstieg bis in die Nähe von $T_c$ und darüber hinaus aufzunehmen und die Anordnung mechanisch noch stabil zu halten.

Dazu werden auf dem Substratrohr dreistreifige Spiralbahnen aufgebracht, wobei z.B. eine Isolatorbahn 10 neben einer $HT_cSL$-Bahn 11 und diese wiederum neben einer Metallbahn 12 liegt (Fig. 2 und 3). Als Metall wird vorzugsweise Kupfer genommen, als Isolatorstreifen z.B. $SrTiO_3$ oder umkristallisiertes kubisches $YBa_2Cu_3O_7$. Die designierte Stromrichtung ist durch einen Doppelpfeil 13 angedeutet.

Eine weitere Bahnenanordnung ist in Fig. 3 gezeigt, die durch Schachtelung des $HT_cSL$ 11 zwischen zwei Metallbahnen 12 z.B. aus Cu zustande kommt. Die Figuren zeigen jeweils einen Oberflächenausschnitt aus einem Spulenkörper.

Eine Abwandlung der Vorrichtung nach Fig. 1, mit der die obigen Strukturen hergestellt werden können, ist in Fig. 4 dargestellt. Hierin bedeuten 14 und 15 je zwei Mikrowellenhörner zur Mikrowelleneinstrahlung in den Reaktorraum und Ausbildung eines Mikrowellenplasmas 5. Diese Hörner können auch um das Reaktorrohr herum verschoben werden, was durch Pfeile angedeutet ist. Ein Laserstrahl 8.1, der über eine Linse 9.1 in etwa senkrecht zur Substratoberfläche im Fokus auftrifft, dient dabei zum Schneiden von Spiralbahnen in leitende oder supraleitende Schichten oder zur Wärmebehandlung.

Eine Bahnstruktur 16 wird dabei durch in der Regel pyrolytische laserinduzierte CVD (LICVD) mittels eines Laserstrahls 8.2 und einer Linse 9.2 aus einem reaktiven Gasgemisch, das für $HT_cSL$-Abscheidung z.B. aus $Ba(hfp)_2$, $Y(thd)_3$ und Cu-$(hfa)_2$ sowie Ar und $O_2$ besteht, sowie zwei weiteren CVD-Prozeßschritten erhalten. Nach jeder Spirallage erfolgt eine Plasmazwischenbehandlung mit $Ar/O_2$. Direkt anschließend an die $HT_cSL$-Spiralbahn wird aus $Cu(hfa)_2$ + $Ar/O_2$ (zum Teil metallisches) Kupfer abgeschieden und nach einer Plasmanachbehandlung mit zunächst $Ar/O_2$ und dann $Ar/H_2$ wird neben der $HT_cSL$-Bahn eine metallisch leitende Cu-Bahn erhalten. Die dritte Spirale aus isolierendem $SrTiO_3$-Material wird entweder ebenfalls per LICVD aus einem reaktiven Gasgemisch von $Sr(hfp)_2$ mit $TiCl_4$ und $Ar/O_2$ (oder $Sr(acac)_2$ + $Ti(OC_3H_7)_4$ + Ar + $O_2$) oder per LICVD zusammen mit PCVD erhalten.

Letzteres bedeutet eine lokalisierte Spiralbahn zusammen mit einer uniformen Überdeckung der Spulenstruktur mit demselben Isolator, die natürlich auch bei einer Trennung der beiden Vorgänge erzielt werden können. Die dritte Möglichkeit ist schließlich, $SrTiO_3$ nur per PCVD auf die $Cu/HT_cSL$-Struktur abzuscheiden, mit einer etwas geänderten Topografie.

Statt eines Mikrowellen- oder Hochfrequenzplasmas kann auch eine Gleichstrom-Glimmentladung verwendet werden, z.B. wenn die Substratoberfläche die Innenseite eines Rohres ist. Die Innenelektrode bzw. beide Elektroden müssen dann z.B. einen Au- oder Ag-Oberflächenüberzug haben oder besser noch durch ein Inertgas wie Ar zusätzlich gespült werden (dann z.B. auch Cu-Elektroden). Ein Laserstrahl kann dann zusätzlich über die Elektrodenzuführung und eine radiale Umlenkung zur Substratoberfläche eingekoppelt werden. Die Elektroden und damit das Plasma werden wiederum periodisch relativ zum Substrat hin- und herbewegt.

Bei dem oben genannten Verfahren können durch Anpassung der Massenflüsse auch die homologen Phasen $Y_2Ba_4 Cu_{6+n}O_{14+n}$ abgeschieden werden und es kann, z.B. für andere supraleitende Phasen $(Ba,Sr)_xLa_{2-x}O_{4-g}$ ohne prinzipielle Änderungen Ba auch durch Sr (oder Ca) in einer entsprechenden metallorganischen Ausgangsverbindung ersetzt werden. Entsprechendes gilt für Y. Schließlich kann Cu auch durch Cu/Ni ersetzt werden, wozu zusätzlich ein Ni-$\beta$-diketonat mit entsprechendem Massenfluß in den Reaktor geleitet wird. Weiterhin ist zu bemerken, daß eine partielle Ersetzung von O durch F in den Hochtemperatursupraleitern die Supraleitung nicht zerstört, so daß Fluordotierungen, die von den fluorierten MO-Verbindungen stammen, nicht stören, anderenfalls aber auch durch eine Ar-Plasma-Zwischenbehandlung entfernt werden können.

Eine weitere Verallgemeinerung der obigen Erfindung ist die PCVD von Erdalkalien bzw. Erdalkalioxid-Metall-Mischsystemen. So wird auch die PCVD-Herstellung von Erdalkalidispenserkathoden bestehend aus W und z.B. 4 BaO CaO $Al_2O_3$ sowie z.B. eine $Sc_2O_3$-Dotierung in W mit den obigen Ba, Ca-MO-Verbindungen möglich, wobei zusätzlich noch bekannte flüchtige und schon für CVD verwendete W- und Al-Ausgangsverbindungen in einen modifizierten Reaktor (z.B. wie in EP-A-0 324 523 beschrieben) mit eingeleitet werden können.

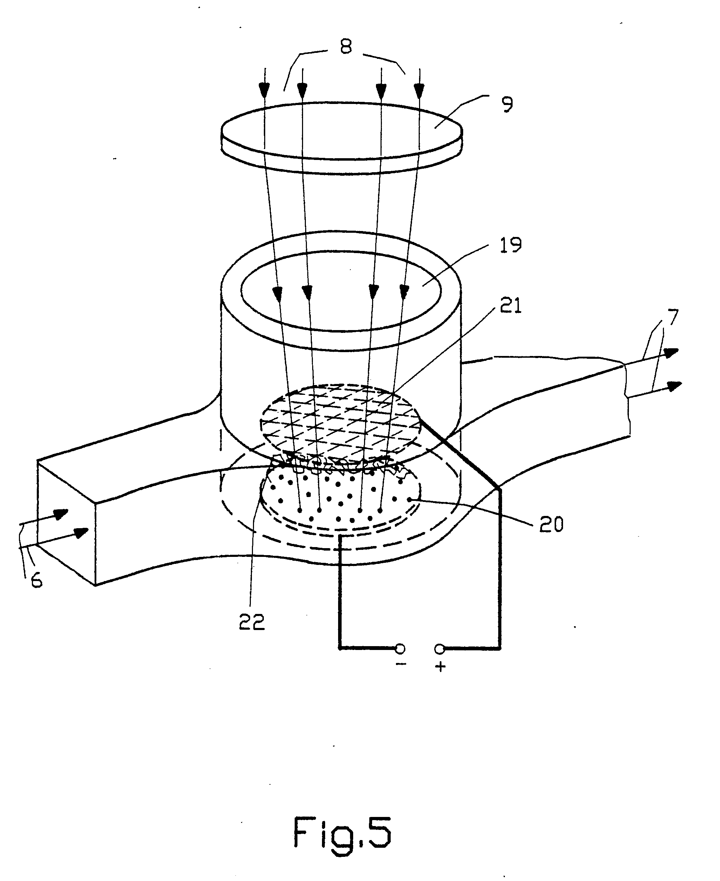

Die wesentlichen Eigenschaften des erfindungsgemäßen Verfahrens und der experimentellen Anordnung sind demnach auch auf die Herstellung von Erdalkali-Nachlieferungskathoden anwendbar. Dabei wird eine Kombination von MO-PCVD mit MO-LICVD und Ar/$O_2$-Plasmazwischenbehandlung in einem Niederdruckreaktor 18 durchgeführt, wobei Niederdruck-Feststoffverdampfer mit MO-Verbindungen, die kurz unterhalb des jeweiligen Schmelzpunktes betrieben werden, in Einsatz kommen. Es wird eine ebene Anordnung verwendet (Fig. 5).

Als metallorganische Ausgangsverbindungen werden $Ba(hfa)_2$, $Ca(hfa)_2$, $Al(acac)_3$ aus Niederdruck-Feststoffverdampfern mit Argon als Trägergas sowie Sauerstoff und für die Wolfram-Abscheidung $W(CO)_6$ verwendet. Das Beugungsbild eines Laserstrahls 8 an einem zweidimensionalen Gitter wird über eine Linse 9 und ein Fenster 19 leicht gebündelt auf ein Substrat 20 eingestrahlt, wodurch auf der Oberfläche ein Punktgittermuster von Flecken hoher Laserintensität entsteht. Es wird insbesondere ein IR-Laser verwendet (CO- oder $CO_2$-Laser), dessen Wellenlänge auf einen (kombinierten) Vibrationsübergang von $W(CO)_6$ oder von den oben genannten MO-Verbindungen abgestimmt ist (insbesondere von Ba-MO-Verbindungen). Zusätzlich kann zwischen dem Substrat als Kathode 20 und einem gegenüberliegenden Drahtgitter 21 als Anode eine Glimmentladung 22 gezündet werden, die insbesondere bei einer intermittierenden Ar/$O_2$-Plasmabehandlung angewendet wird. Es entsteht so eine dreidimensionale I-Kathodenstruktur mit einzelnen senkrechten bariumreichen Kanälen. Eine weitere Möglichkeit ist die Erzeugung eines Whiskerrasens von W mit W-CVD bei höherem Druck und anschließender MOCVD zur Verfüllung mit 4 BaO . CaO . $Al_2O_3$ bei niedrigerem Druck, ebenfalls mit intermittierender Plasmabehandlung. Zusätzlich kann auch $Sc_2O_3$ über $Sc(tfa)_3$ mit abgeschieden werden und man erhält eine Scandat-Kathode. Auch selektives Wachstum auf einem vorgegebenen Substratoberflächenmuster kann ausgenutzt werden.

**Ansprüche**

1. Verfahren zur Herstellung von erdalkalimetallhaltigen und/oder erdalkalimetalloxidhaltigen Materialien durch plasmaaktivierte reaktive Abscheidung aus der Gasphase, wobei mindestens eine metallorganische Verbindung der Erdalkalimetalle in die Gasphase überführt wird, dadurch gekennzeichnet, daß die metallorganischen Verbindungen der Erdalkalimetalle aus jeweils einem Niederdruck-Feststoffverdampfer mittels eines ein Inertgas und/oder ein oxidierendes Gas enthaltenden Trägergases in ein Entladungsgefäß überführt werden, in dem Entladungsgefäß ein Gesamtdruck im Bereich von 0,1 bis 50 hPa eingestellt wird und ein Plasma erzeugt wird, und wiederholt-intermittierend zur plasmaaktivierten Abscheidung aus einer die metallorganischen Verbindungen und das oxidierende Gas als reaktive Gase und das Inertgas enthaltenden Phase eine Argon/Sauerstoff-Plasma-Zwischenbehandlung durchgeführt wird.

2. Verfahren nach Anspruch 1,
dadurch gekennzeichnet, daß zur Plasma-Aktivierung der reaktiven Gase ein Mikrowellenplasma, ein Hochfrequenzplasma und/oder eine Gleichstromglimmentladung angewendet werden.

3. Verfahren nach Anspruch 1 und 2,
dadurch gekennzeichnet, daß das Plasma, vorzugsweise ein Mikrowellenplasma, durch ein mikrowellendurchlässiges Außenrohr in einen als Entladungsgefäß dienenden koaxialen Doppelrohrreaktor eingekoppelt wird und periodisch längs der Achse mittels der Bewegung des über einen Schlitz nach innen offenen koaxialen Mikrowellenresonators hin- und herbewegt wird.

4. Verfahren nach Anspruch 1 bis 3,
dadurch gekennzeichnet, daß zur Abscheidung von erdalkalihaltigen oxidischen Hochtemperatursupraleitern ($HT_cSL$) das Innenrohr als Substratrohr auf metallischer Unterlage ausgebildet ist, wobei die Gitterkonstanten des Substratmaterials möglichst genau an die Gitterkonstanten des zu erzielenden $HT_cSL$-Materials angepaßt sind.

5. Verfahren nach Anspruch 1 bis 4,
dadurch gekennzeichnet, daß aus Y-, Ba- und Cu-$\beta$-diketonaten als Ausgangsverbindungen auf dem Innenrohr mit $SrTiO_3$, MgO oder CuO als Substratmaterial die orthorhombische $HT_cSL$-Phase $YBa_2Cu_3O_{7-\delta}$ oder die homologen $HT_cSL$-Phasen $Y_2Ba_4Cu_{6+n}O_{14+n}$ per PCVD abgeschieden werden.

6. Verfahren nach Anspruch 1,
dadurch gekennzeichnet, daß die mittleren Niederdruckverdampfer-Innendrücke nahe bei dem Druck im Entladungsgefäß bei der durchgeführten Niederdruck-PCVD liegen und zur Erzielung von hohen Massenflüssen von metallorganischen Verbindungen hohe Inert-Trägergasflüsse eingestellt werden.

7. Verfahren nach Anspruch 1 und 6,
dadurch gekennzeichnet, daß die thermostatisierten Verdampfertemperaturen kurz unterhalb des jeweiligen Schmelzpunktes der jeweiligen metallorganischen Ausgangsverbindungen eingestellt werden.

8. Verfahren nach Anspruch 1,
dadurch, gekennzeichnet, daß zusammen mit der/den metallorganischen Erdalkaliverbindungen, insbesondere Erdalkali-$\beta$-diketonaten, andere metallorganische Ausgangsverbindungen von Übergangsmetallen, insbesondere der Sc-Gruppe und der Seltenen Erden, aus jeweils einem Niederdruckverdampfer über getrennt gesteuerte Trägergasflüsse in das Entladungsgefäß eingeleitet werden und/oder flüchtige anorganische oder organische Ausgangsverbindungen von Übergangsmetallen, z.B. die entsprechenden Halogenide, mit gesteuertem Massenfluß direkt in das Entladungsgefäß eingeleitet werden.

9. Verfahren nach Anspruch 1,
dadurch gekennzeichnet, daß die wenig flüchtigen metallorganischen Ausgangsverbindungen, insbesondere der Erdalkalien, mit dem Trägergas in Feinstpulverform in das Entladungsgefäß überführt und dort im Plasma zerlegt werden.

10. Verfahren nach Anspruch 3, 4 und 5,
dadurch gekennzeichnet, daß durch das Außenrohr ein fokussierter Laserstrahl, vorzugsweise mit Wellenlänge im IR, insbesondere ein $CO_2$-Laserstrahl, mit Fokus im Bereich der Substratoberfläche, eingestrahlt wird und vermittels einer Laserstrahl- und/oder Substratrelativbewegung, insbesondere vermittels einer Kombination von Fokustranslation und Substratrohrrotation, spiralförmige gewendelte Unterbrechungen in die vorher abgeschiedene $HT_cSL$-Schicht geschnitten werden.

11. Verfahren nach Anspruch 10,
dadurch gekennzeichnet, daß auf die nach Anspruch 10 hergestellte einlagige $HT_cSL$-Spule per PCVD eine Isolationsschicht (z.B. CuO, MgO) abgeschieden wird und anschließend eine erneute $HT_cSL$-Schicht abgeschieden, mit einem Laserstrahl spiralförmig geschnitten, der Gesamtprozeß für Einzelspulenschichten mehrfach wiederholt wird, wobei die Einzelspulenkontaktierung und Verbindung zu einer mehrlagigen $HT_cSL$-Spule dadurch erfolgt, daß an den jeweiligen Kontaktstellen keine Isolationsschicht abgeschieden bzw. diese über Laserstrahlverdampfen dort wieder entfernt wird.

12. Verfahren nach Anspruch 1, 3, 4 und 5,
dadurch gekennzeichnet, daß eine Temper-Nachbehandlung bei 800 bis 900° C unter $O_2$- oder Ar/$O_2$- oder $N_2$/$O_2$-Atmosphäre durchgeführt wird zur Fein-Einstellung des Sauerstoffgehalts und der $HT_cSL$-Phase, speziell der orthorhombischen $YBa_2Cu_3O_{7-\delta}$-Phase.

13. Verfahren nach Anspruch 12,
dadurch gekennzeichnet, daß die Temper-Nachbehandlung vermittels eines parallelen oder fokussierten Laserstrahls, der durch das Außenrohr auf das Substratrohr gestrahlt wird, bei erhöhtem Druck in der Ar/$O_2$-, $O_2$- oder $N_2$/$O_2$-Gasatmosphäre, insbesondere bei 50 bis 500 hPa, direkt im Entladungsgefäß durchgeführt wird.

14. Verfahren nach Anspruch 1, 2 und 8,
dadurch gekennzeichnet, daß zur Herstellung von Erdalkali-Nachlieferungskathoden zusätzlich zu Ba-$\beta$-diketonat aus einem Niederdruck-Feststoffverdampfer, Ca-$\beta$-diketonat aus einem Niederdruck-Feststoffverdampfer per Ar oder Ar/$O_2$ als Trägergase sowie eine metallorganische Al-Verbindung, z.B. Tri-isobutyl-Aluminium = $Al(C_4H_9)_3$ und/oder alternierend eine flüchtige Wolfram-Verbindung, insbesondere $WF_6$ mit Wasserstoff in das Entladungsgefäß geleitet werden, in dem eine Gleichstromglimmentladung gezündet wird, und dort eine Kathodenstruktur abgeschieden wird.

15. Verfahren nach Anspruch 14, dadurch gekennzeichnet, daß auf die Kathodenstruktur nach vermittels einer im Anschluß zusätz- lich eingeleiteten metallorganischen Sc-Verbin- dung, insbesondere von Sc-$\beta$-diketonat, mit Ar/O$_2$ und/oder alternierend WF$_6$/H$_2$ eine Sc$_2$O$_3$ + W- Deckschicht abgeschieden wird.

Fig.1

Fig.2

Fig.3

Fig.4

Fig.5